# EUROPEAN PATENT SPECIFICATION

(11) **EP 0 312 170 B1**
(45) Date of publication and mention of the grant of the patent: **01.12.1993**
(21) Application number: 88202266.8
(22) Date of filing: 11.10.1988
(51) Int. Cl.: H01L 21/00, H01L 21/84

(54) **Process for step and repeat vacuum-deposition of large-area thin-film transistor matrix-circuits on monolithic glass panels through perforated metal masks**
Verfahren zur Bedampfung im Vakuum im Repetierschrittverfahren von grossflächigen Dünnfilmtransistorenmatrizenschaltungen auf Glaspaneelen durch perforierte Metallmasken
Procédé pour le dépôt sous vide, pas à pas et avec répétition, de circuits matrices de transistors à couche mince sur des panneaux en verre monolithique à travers des masques em métal perforés

(30) Priority: 14.10.1987 DE 3734770
(43) Date of publication of application: 19.04.1989
(73) Proprietor: ENICHEM S.p.A., 20122 Milano (IT)
(72) Inventor: Tizabi, Djamshid, D-4600 Dortmund 1 (DE); Fisher, Albert G., D-4600 Dortmund 50 (DE)
(74) Representative: Fusina, Gerolamo

(56) References cited:
- US-A- 3 840 695
- CONFERENCE RECORD OF 1982 INTERNATIONAL DISPLAY RESEARCH CONFERENCE SID-IEEE 19 October 1982, PISCATAWAY,N.J.08854 (US) pages 161 - 165; A.G. FISCHER ET AL.: "Mass-producible TFT-LC modules for square-meter-sized or pocket-sized flat TV panels"
- NTZ NACHRICHTECHNISCHE ZEITSCHRIFT. vol. 33, no. 2, February 1980, BERLIN DE pages 80 - 88; A. FISCHER: "Flache Fernseh-Bildschirme"
- NTZ NACHRICHTECHNISCHE ZEITSCHRIFT. vol. 33, no. 3, March 1980, BERLIN DE pages 162 - 169; A. FISCHER: "Flache Fernseh-Bildschirme"
- NTZ NACHRICHTECHNISCHE ZEITSCHRIFT. vol. 33, no. 4, April 1980, BERLIN DE pages 230 - 236; A. FISCHER: "Flache Fernseh-Bildschirme"

## Description

The rear-illuminated, matrix-addressed liquid crystal colour TV set invented by Fischer 1972 (US-Pat. 3,840,695 (1974)) can compete against the tubular TV world only if it can be fabricated with a larger display area than what is achievable with tubular TV displays, for example with a size of 90 x 120 cm for the living room wall.

For this, the requisite thin-film electronics matrix, which has to be placed directly behind the liquid crystal light-controlling film for addressing and storage, would have to be deposited onto one large, monolithic glass panel (1). However, with the presently-available techniques for semiconductor film preparation such as vapour phase epitaxy or sputtering with subsequent contouring by etching through fotoresist, or by vacuum deposition of these films by electron-beam-evaporation through fotoresist masks or through sheet metal masks, the production of monolithic, square-meter sized display panels is still not possible today. The reasons are:
the requisite apparatus is too large and too expensive; the required fotoresist technology, and the optical lense technology, do not yet exist for such large formats, and/or perforated metal masks of this size cannot yet be made with the required accuracy. Further, these processes would not be automatable, thus would require expensive human handiwork. Therefore, the maximum available mask size today is 20 x 30 cm. For this display area size, however, there are excellent and inexpensive tubular TV sets on the market which are hard to compete with by our novel flat panels.

In order to nevertheless penetrate into the square-meter range, one can compose the large liquid crystal display area of many small "modules" (see A.G. Fischer, Dj. Tizabi, K. Krusch, H. Teves, 1982 Internat. Display Research Conference SID-IEEE Cherry Hill N. J., Proceedings p. 161). However, if one composes the large area, i.e. 90 x 120 cm. of 100 modules each sized 9 x 12 cm, the minimization of the visible crevices between adjacent modules, and the reliable production of the thousands of requisite electro-mechanical contacts between adjacent modules, create near-insurmountable difficulties.

In our desire to find a path toward large-area flat LC TV despite these difficulties during out technology which we developed for small flat displays during the past years, we invented the method and the machine for its realization to be described below, which are verified already in the important elementary details.

As we reviewed 1980 (A. Fischer, NTZ 33, p. 80; 162; 230 (1980)), we fabricate our little (9 x 12 cm, 100 lines and 100 columns) thin-film transistor matrices by high-vacuum deposition by means of electron beam-heated evaporation, from only a few simple materials, fully automatedly, through several, exchanged perforated bimetal masks, onto cold glass panes.

In out approach the masks (3) consist of a "bachbone" sheet of 70 um thick iron-nickel foil ("INVAR", this has a thermal expansion coefficient as low as that of quartz glass,) which is coated with an electroplated-on film of hard gold-cobalt alloy 3 um thick, into which the actual mask pattern is etched with high accuracy. These thin mask foils are precision-mounted onto sturdy, machined INVAR frames (2) with special adhesive under control via a double microscope, using build-in registration marks for calibration. The registration of the selected mask (3) with the glass panel (1) and its previous deposition patterns is achieved by means of ball pins (12) and funnel sockets (13). These are very inexpensive precision fittings; the ball pins (12) consists of stainless steel ball bearing balls of 5.000 mm diameter which are spotwelded onto steel pins. The funnel sockets (13) are lathed and honed on automated machines, they have 5.002 um diameter at the narrow end of the funnel.

These framed masks (3,2) and their precision fittings (12,13) are useable thousands of times; after a few hundred evaporations they can be cleaned by immersion into dilute hydrofluoric acid. However, they can not be made much larger than presently.

The present invention relates to the extension of our previously-published small-display technology to the production of much larger, square-meter-sized matrices. This is accomplished by means of reticulated repeated succesive vacuum deposition through our small perforated masks (3) such that the large-area reticulated display matrix can be fabricated without crevices and discontinuities. For this, the problem of exact registration of adjacent reticles had to be solved.

Moreover, since this large display area has to be produced by numerous individual operations, it is imperative that these operations be easily accessible to full automation.

All this has been accomplished in our present invention.

In our previous mini-display project, the matrix sized 9 x 12 cm containing 100 lines and 100 columns = 10000 pixels was electron-beam-vacuum deposited from a 6-crucible hearth holding 6 materials, through 9 perforated, framed masks which were placed onto the substrate glass pane with exact registration. Before each individual evaporation, the glass substrate was lowered onto the requisite mask which was drawn out of a chest-like reservoir, and registered by means of two couples of ballpins and funnel-sockets, the two ballpins mounted on opposite corners of the mask frames, and the two funnel-sockets being mounted at opposite corners of the substrate holding plate, see, e.g., A. Fischer, Nachrichtentechnische Zeitschrift NTZ 33, p. 30, p. 162, p. 230 (1980).

To allow for thermal expansion of the INVAR plates, the hole in one of the funnel sockets is not round but elongated, in a direction opposing the other socket (see Fig. 1C).

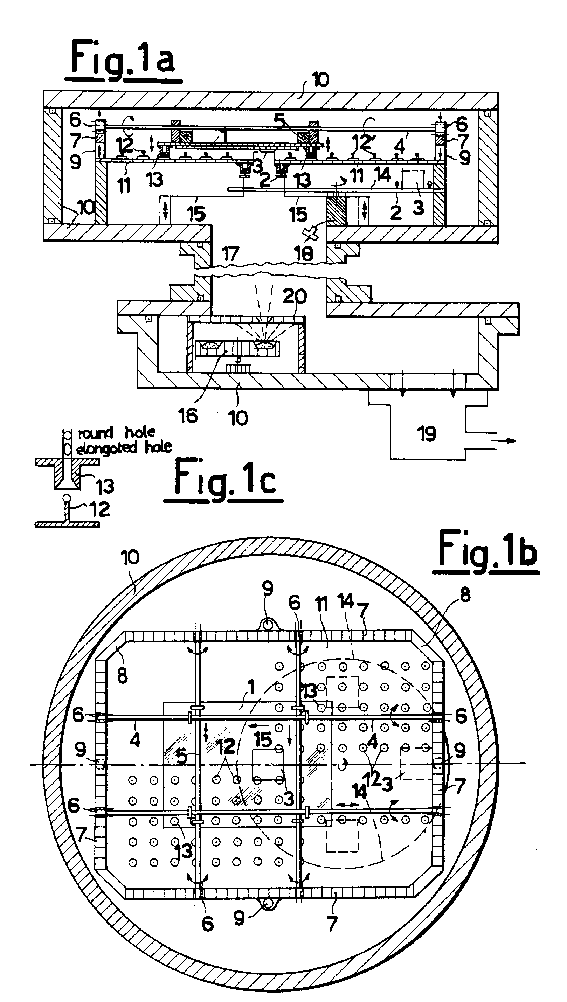

Figures 1a and 1b show the machine to carry out the process according to claim 1:
the large glass panel (1) below its INVAR holding plate is movable in X and Y direction such that new surface reticles of it can be placed above the evaporation chimney (2) and the selected mask (3). This is accomplished via two rotating rods extending in X direction, (4), and two rotating rods extending in Y direction (5), which are mounted in bearing blocks on the upper side of the holding plate, and which carry, at their ends, toothed gears (6) which mesh in the four toothed bars (7), in which they progress driven by stepper motors. The four bars (7) form a stiff rectangular frame (8) which can be raised or lowered evenly by means of four lifting devices (9) (e.g. pneumatic bellows), and which are finally mounted firmly on four columns attached to the vacuum vessel (10).

Below this movable glass panel (1) we have a large, intermediate INVAR plate (11) which is firmly mounted to the vacuum vessel (10), and which has an opening above the evaporation chimney (2). On its upper surface this plate (11) carries numerous ballpins (12) which are spaced such that a pair of these ballpins (12) fit into the two funnel sockets (13) that are mounted at the underside on two opposing corners of the holding plate if the glass panel (1) has been shifted into a new reticle position and lowered by means of the lifting devices (9). Thus, as soon as an approximately-proper position of glass panel (1) has been reached by X-Y-shifting, panel (1) which is held by rod pair (4) and rod pair (5) on the toothed bar frame (8) is lowered with (8) via the lifting devices (9) such that the selected pair of ballpins (12) will slide into the two funnel sockets (13) below the holding plate, for exact registration of the glass panel (1) onto the intermediate plate (11). Now the selected framed mask (3) has to be mated with the selected reticle of the glass panel (1) from underneath.
For this, our previously-practiced way of mask storage in the form of a "chest of drawers" had to be abandoned (since this would result in selected masks as different levels of altitude), in favour of a mask storage in the form of a rotating disk or caroussel (14). This caroussel (14), which has elong its circumference openings holding the framed masks (3), is located below the intermediate INVAR plate (11). By rotating this disk (14), each mask can be brought successively into the evaporation chimney (2).
Now this selected mask (3) has to be lifted to the selected reticle of the glass panel (1). For this purpose, a lifting stage (15) (which may be agitated pneumatically, for example) touches the selected frame mask (2, 3) from below and raises it from its storage opening of the caroussel (14), through the opening in the firmly-mounted INVAR plate (11), until it touches the underside of the glass panel (1). During this operation, the two ball pins (12) that are mounted on the upper face of the mask frame (2) of (3) will slip into the corresponding two funnel sockets (13) which are attached to opposing corners of the firmly-mounted INVAR plate (11), for accurate registration. The vacuum deposition of one reticle can now begin.
The electron-beam-heated, multiple evaporation source (16) having, e.g., 6 crucibles with 6 different evaporation materials, is located at the lower end of the evaporation chimney (17). The selection of the particular crucible with its material, and the parameters needed for the respective film to be vacuum-deposited through the selected mask (3) onto the selected reticle of glass pane (1), are stored in and delivered by the computer. A vibrating quartz crystal sensor (18) that is mounted at the upper end of the evaporation channel (17) near the panel (1) , with its requisite electronics, is used for monitoring the achieved film thickness.
The multiple evaporation source (16) is housed in a box (20) made of thick copper plates. This box has a rectangular hole at its top to allow a vapour beam to exit which is just sufficiently narrow to coat the mask (3) and the glass panel reticle (1), not the walls of the chimney. The unneeded film deposits inside the box (20) and at the underside of the masks (3) have to be removed and dissolved, after a few hundred evaporation cycles, by dipping these parts into dilute, boric-acid-buffered hydrofluoric acid.
In this way the flaking-off of these built-up deposits is avoided; such flasks would create faults in the evaporated layers at the glass panel (1).

At the lower end of the evaporation chimney (17) is also attached the high vacuum pump (19) with its large plate valve (not shown), and the fore vacuum pump (not shown), as well as sensors to measure the vacuum (not shown). Other vacuum sensors (not shown) are placed at the upper vacuum chamber near the glass substrate.
The electronic position sensors which monitor the completion of each process movement we employ tiny magnets which move with the mobile components of the machine past the relais and agitate these reed relais which are attached to the immobile components.

The initial adjustment of all ball pin / funnel socket pairs is carried out, after one calibration vacuum deposition for each reticle using titanium metal, by placing a light source at the evaporation source (16) and by observing the light spots at the panel (1) (made visible there by means of a thin translucent paint film) using a double microscope which permits simultaneous inspection of two diametrically opposed spots on each mask. The ball pins and funnel sockets are initially installed into approximate positions loosely by means of slots and little screws. Once exact registration has been reached by means of shifting under the microscope, these fittings are firmly positioned by means of a drop of "One-Second-Glue", and then the little screws are tightened.

With this new method and means as described above, and modifications thereof which are evident to anyone skilled in the art, it is possible to produce monolithic large-area (e.g. square-meter-sized) thin-film electronic circuit matrices on glass panes, which are suitable - amongst other possible applications - to address large-area light-controlling and light-emitting layers for display panels, especially wall panel television sets.

## Claims

1. Process for manufacturing a monolithic square-metre-sized matrix of thin-film transistors on a large-size glass panel (1) for a flat, square-metre-size liquid-crystal television display screen, said process consisting in a reticulated repeated successive vacuum deposition of thin-film transistor matrices smaller than said square-metre-sized matrix; whereby each of said smaller matrices including its corresponding peripheral shift and storage registers is vacuum deposited onto a reticule of said large-size glass panel, which is not intentionally heated, from a multiple-source evaporator (16), through a number of exchangeable perforated metal foil masks (3), said deposition masks (3) being successively pressed against one reticule of said glass panel (1) in exact registration with each other mask and with neighbouring reticules, to thereby deposite respective films of said thin-film transistors; and whereby said glass panel (1) is then shifted stepwise, in exact registration, to expose a new reticule to the multiple vacuum deposition, and so forth, until completion of the whole square-metre-sized matrix of thin-film transistors, all these operations proceeding fully automatedly and computer-controlled.

2. Process according to Claim 1, wherein the large-size glass panel (1) is clamped under a low-expansion iron-nickel holding plate, which contains on its upper face four precision-machined round rods (4,5) supported by ball-bearings and which are rotated by electronic-controlled step-motors, said rods (4,5) are terminated by toothed gears (6) travelling on four precision-toothed bars (7) which form a rectangular frame (8), the perpendicular edges of said rectangular frame (8) define a X-Y direction system; thereby two of the rods (4,5) extending in X direction and the other two extending in Y direction; said rectangular frame (8) is mounted in the vacuum bell jar (10) in such a way that the large-size glass panel (1) can be shifted in X and Y directions into the approximate positions where the reticular vacuum depositions can take place.

3. Process according to Claims 1 and 2, wherein as the glass panel (1) reaches an approximate proper X-Y reticule position, can be lowered, via lifts (9), onto an intermediate, firmly-mounted iron-nickel plate (11) which contains, on its upper face, a reticled raster of numerous precision ball pins (12) which are exactly located such that, with the glass panel (1) lowered in reticle position, two of the ball pins (12) fit into the two precision funneled socket fittings (13) that are mounted on opposed corners at the underside of the holding plate, such that the glass panel (1) is now registered, in each reticle position, to this intermediate iron-nickel plate (11).

4. Process according to Claims 1, 2 and 3, wherein the selected mask (3), tensioned on a metal frame, is lifted upwards through an evaporation chimney opening (2) formed through the intermediate metal plate (11) and is pressed against the substrate glass panel (1), whereby the reticule positioning takes place through two ball-terminated pins (12) diametrically provided on the top face of the mask frame, said pins (12) fitting into corresponding funnel-shaped sockets (13) provided on the lower face of said intermediate metal plate (11).

5. Process according to Claims 1, 2, 3 and 4, wherein the masks (3) together with their frames are stored into openings (21) formed along the circumference of a metallic caroussel disc (14) located below the intermediate metal plate (11), and a preselected mask (3) can be placed into the evaporation chimney (2) by controlled rotation of the caroussel (14), from where it then can be lifted, by means of a lifting stage (15), through the central opening of the intermediate plate (11) until it contacts the large glass panel (1), whereby the two ballpins (12) on the mask frame slip into the two funnel sockets (13) underneath the central opening of the intermediate plate (11) for mask registration.

6. Process according to Claims 1, 2, 3, 4 and 5, wherein after the positioning and registration of the glass panel (1) and of each mask (3), the upwardly vacuum deposition with the selected material proceeds in high vacuum from the rotary multiple source electron-beam evaporator (16).

## Patentansprüche

1. Verfahren zum Herstellen einer monolithischen quadratmetergroßen Matrix aus Dünnfilmtransistoren auf einer großformatigen Glastafel (1) für einen flachen quadratmetergroßen Flüssigkristall-Fernsehbildschirm, welches Verfahren in einer netzartig wiederholten aufeinanderfolgenden Vakuumablagerung von Dünnfilmtransistormatrizen besteht, die kleiner als die genannte quadratmetergroße Matrix sind; wobei jede der kleineren Matrizen mit ihren korrespondierenden, am Umfang angeordneten Schiebe- und Speicherregistern auf einem Netzelement der großformatigen, nicht absichtlich beheizten Glastafel von einem Mehrfachquellen-Verdampfer (16) durch eine Anzahl austauschbarer perforierter Metallfolienmasken (3) abgelagert wird, welche Ablagerungsmasken (3) aufeinanderfolgend gegen ein Netzelement der Glastafel (1) in exakter Ausrichtung mit jeder anderen Maske und mit benachbarten Netzelementen gepreßt werden, um dadurch die einzelnen Filme der Dünnfilmtransistoren abzulagern; und wobei die Glastafel (1) dann schrittweise in exakter Ausrichtung verschoben wird, um ein neues Netzelement der Mehrfachvakuumablagerung auszusetzen, und so fort, bis zur Vervollständigung der gesamten quadratmetergroßen Matrix aus Dünnfilmtransistoren, wobei alle diese Schritte vollautomatisiert und computergesteuert ablaufen.

2. Verfahren nach Anspruch 1, bei welchem die großformatige Glastafel (1) unter einer Eisen-Nickel-Halteplatte mit geringer Expansion eingespannt wird, welche auf ihrer Oberseite präzisionsbearbeitete Rundstäbe (4, 5) aufweist, die in Kugellagern gelagert und von elektronisch gesteuerten Schrittmotoren in Drehung versetzt werden, wobei die Stäbe (4, 5) in Zahn-ritzeln (6) enden, welche auf vier mit einer Präzisionszahnung versehenen Stangen (7) ablaufen, die einen rechteckigen Rahmen (8) bilden, wobei die senkrechten Kanten des rechteckigen Rahmens (8) ein X/Y-Richtungssystem definieren; wobei zwei der Stäbe (4, 5) sich in X-Richtung erstrecken und die anderen beiden in Y-Richtung; wobei der rechteckige Rahmen (8) in der Vakuumglocke (10) so montiert ist, daß die großformatige Glastafel (1) in X- und Y-Richtung in annähernd die Positionen verschoben werden kann, wo die netzartigen Vakuumablagerungen stattfinden können.

3. Verfahren nach den Ansprüchen 1 und 2, bei welchem die Glastafel (1), wenn sie eine annähernd richtige X/Y-Netzposition erreicht, mit Hilfe von Hebeeinrichtungen (9) auf eine zwischenliegende, fest montierte Eisen-Nickel-Platte (11) abgesenkt werden kann, die einen netzartigen Raster aus zahlreichen Präzisions-Kugelstiften (12) aufweist, welche exakt so angeordnet sind, daß bei in die Netzposition abgesenkter Glastafel (1) zwei der Kugelstifte (12) in zwei als Präzisionstrichter ausgebildete Sockelanschlußstücke (13) passen, welche an gegenüberliegenden Ecken auf der Unterseite der Halteplatte montiert sind, so daß die Glastafel (1) nun in jeder Netzposition mit dieser zwischenliegenden Eisen-Nickel-Platte (11) ausgerichtet ist.

4. Verfahren nach den Ansprüchen 1, 2 und 3, bei welchem eine ausgewählte, auf einem Metallrahmen aufgespannte Maske (3) durch eine Dampfabzugsöffnung (2) nach oben angehoben wird, die in der zwischenliegenden Metallplatte (11) ausgebildet ist, und gegen die Substratglastafel (1) gepreßt wird, wobei die Netzpositionierung mit Hilfe zweier in Kugeln endender Stifte (12) erfolgt, die diametral auf der Oberseite des Maskenrahmens angeordnet sind, wobei die Stifte (12) in korrespondierende trichterförmig ausgebildete Sockel (13) passen, die auf der Unterseite der genannten zwischenliegenden Metallplatte (11) angeordnet sind.

5. Verfahren nach den Ansprüchen 1, 2, 3 und 4, bei welchem die Masken (3) zusammen mit ihren Rahmen in Öffnungen (21) aufbewahrt werden, die entlang des Umfanges einer metallischen Karusselscheibe (14) ausgebildet sind, welche unter der zwischenliegenden Metallplatte (11) angeordnet ist, und eine vorgewählte Maske (3) in den Dampfabzug (2) durch gesteuerte Verdrehung des Karussels (14) eingebracht werden kann, von wo sie dann mit Hilfe einer Hebestufe (15) durch die zentrale Öffnung der Zwischenplatte (11) angehoben werden kann, bis sie die große Glastafel (1) berührt, wobei die beiden Kugelstifte (12) auf dem Maskenrahmen in die beiden Trichtersockel (13) unterhalb der zentralen Öffnung der Zwischenplatte (11) zur Ausrichtung der Maske gleiten.

6. Verfahren nach den Ansprüchen 1, 2, 3, 4 und 5, bei welchem nach dem Positionieren und Ausrichten der Glastafel (1) und jeder Maske (3) die aufwärts gerichtete Vakuumablagerung mit dem gewählten Material in Hochvakuum ausgehend von dem rotierenden Mehrfachquellen-Elektronenstrahlverdampfer (16) erfolgt.

## Revendications

1. Procédé pour fabriquer une matrice monolithique, de la taille du mètre carré, de transistors à film ou couche mince, sur un panneau de verre (1) de grande dimension pour un écran plat de télévision, à cristaux liquides, de la taille du mètre carré, ledit procédé consistant en un dépôt sous vide successif, répété, réticulé, de matrices de transistors à film mince plus petites que ladite matrice de la taille du mètre carré, chacune desdites matrices plus petites, comprenant ses registres à décalage et de mémorisation périphériques correspondants, étant déposée sous vide sur un réseau dudit panneau de verre de grande dimension, qui n'est pas chauffé volontairement, à partir d'un évaporateur (16) à sources multiples, à travers un grand nombre de masques en feuille métallique mince, perforés et échangeables (3), lesdits masques de déposition (3) étant pressés successivement contre un des réseaux dudit panneau de verre (1) en coïncidence exacte avec chaque autre masque et avec les réseaux voisins, de manière à déposer ainsi les films respectifs desdits transistors à film mince ; et le panneau de verre (1) étant ensuite déplacé pas à pas, en coïncidence exacte, de manière à exposer un nouveau réseau au dépôt sous vide multiple, et ainsi de suite, jusqu'à ce que soit complétée toute la matrice de transistors à film mince, de la taille du mètre carré, toutes ces opérations étant effectuées entièrement de façon automatique sous la commande d'un ordinateur.

2. Procédé selon la revendication 1, dans lequel le panneau de verre (1) de grande dimension est bloqué sous une plaque de support en fer-nickel à faible coefficient de dilatation, qui contient sur sa face supérieure quatre tiges rondes (4, 5) usinées avec précision et supportées par des roulements à billes et qui sont entraînées en rotation par des moteurs pas-à-pas commandés électroniquement, lesdites tiges (4, 5) se terminant par des roues dentées (6) se déplaçant sur quatre crémaillères (7) à denture de précision qui forment un cadre rectangulaire (8), les bords perpendiculaires dudit cadre rectangulaire (8) définissant un système de direction X-Y de manière que deux des barres (4, 5) s'étendent dans la direction X et les autres deux barres s'étendent dans la direction Y, ledit cadre rectangulaire (8) étant monté dans une cloche à vide (10) de telle manière que le panneau de verre (1) de grande dimension peut être déplacé dans les directions X et Y jusqu'aux positions approximatives où les dépôts sous vide réticulaires peuvent avoir lieu.

3. Procédé selon les revendications 1 et 2, dans lequel, lorsque le panneau de verre (1) atteint une position du réseau X-Y appropriée approximative, il peut être abaissé, à l'aide d'un moyen élévateur (9), jusque sur une plaque de fer-nickel intermédiaire (11) montée fermement et comportant, sur sa face supérieure, une disposition en réseau de nombreux pions à boules (12) de précision qui sont placés de façon exacte, de telle sorte que, le panneau de verre (1) étant abaissé dans une position de réseau, deux des pions à boules (12) s'encastrent dans deux douilles d'assemblage de précision (13) en forme d'entonnoir qui sont montées sur des coins opposés sur le côté de dessous de la plaque de support, ce qui fait que le panneau de verre (1) coïncide maintenant, dans chaque position de réseau, avec cette plaque de fernickel intermédiaire (11).

4. Procédé selon les revendications 1, 2 et 3, dans lequel le masque sélectionné (3), tendu sur un cadre métallique, est soulevé à travers une ouverture de cheminée d'évaporation (2) formée à travers la plaque métallique intermédiaire (11) et est pressé contre le panneau de verre (1) formant substrat, le positionnement de réseau ayant lieu à l'aide de deux pions à boules (12) disposés diamétralement sur la face supérieure du cadre-masque, lesdits pions (12) s'encastrant dans deux douilles correspondantes (13) en forme d'entonnoir présentes sur la face inférieure de la plaque métallique intermédiaire (11).

5. Procédé selon les revendications 1, 2, 3 et 4, dans lequel les masques (3), conjointement avec leurs cadres, sont stockés dans des ouvertures (21) formées le long de la circonférence d'un disque métallique (14) de carrousel situé en-dessous de la plaque métallique intermédiaire (11) et un masque sélectionné préalablement (3) peut être placé dans la cheminée d'évaporation (2) par rotation commandée du carrousel (14), depuis l'endroit où il peut alors être soulevé, au moyen d'un étage élévateur (15), à travers l'ouverture centrale de la plaque intermédiaire (11) jusqu'à ce qu'il vienne en contact avec le panneau de verre (1) de grande dimension, les deux pions (12) à boules se trouvant sur le cadre-masque pénétrant par glissement dans les deux douilles (13) en entonnoir sous l'ouverture centrale de la plaque intermédiaire (11) pour une coïncidence des masques.

6. Procédé selon les revendications 1, 2, 3, 4 et 5, dans lequel après le positionnement et la mise en coïncidence du panneau de verre (1) et de chaque masque (3), le dépôt sous vide en direction du haut à l'aide de la matière sélectionnée a lieu sous une vide élevé depuis l'évaporateur (16) à faisceau électronique et à sources multiples.
